# EUROPEAN PATENT APPLICATION

(11) **EP 3 929 596 A1**
(43) Date of publication of application: **29.12.2021**
(21) Application number: 20759537.2
(22) Date of filing: 27.01.2020
(51) Int. Cl.: G01R 15/20

(54) **THREE-PHASE CURRENT DETECTION DEVICE**

(30) Priority: 18.02.2019 JP 2019026599
(71) Applicant: Panasonic Intellectual Property Management Co., Ltd., Osaka-shi, Osaka 540-6207 (JP)
(72) Inventor: HASHIMOTO, Toshio, Chuo-ku, Osaka-shi, Osaka 540-6207 (JP); KAMIMOTO, Ryuichi, Chuo-ku, Osaka-shi, Osaka 540-6207 (JP); SAITO, Hiroyuki, Chuo-ku, Osaka-shi, Osaka 540-6207 (JP); YAMAMOTO, Akio, Chuo-ku, Osaka-shi, Osaka 540-6207 (JP)
(74) Representative: Vigand, Philippe
(86) International application number: PCT/JP2020/002824
(87) International publication number: WO 2020/170724

(57) **Abstract**

A three-phase current detection device is configured to be used with first to third conductors allowing respective three-phase currents to flow therethrough in a flow direction, and is configured to detect the three-phase currents. The three-phase current detection device includes a substrate, a grounding wiring provided on the substrate, first to third loop magnetic cores, first to third magnetoelectric conversion elements, and first to third grounding electrodes. The first to third loop magnetic cores are extended along first to third loop lines surrounding the first to third conductors, the first to third loop lines are on a plane perpendicular to the flow direction, the first to third loop magnetic cores have first to third magnetic gaps, respectively. The first to third magnetoelectric conversion elements are disposed in the first to third magnetic gaps, respectively. The first to third grounding electrodes are connected to the grounding wiring, contact the first to third loop magnetic cores, and press the first to third loop magnetic cores in first to third pressing directions perpendicular to the flow direction, respectively.

## Description

### TECHNICAL FIELD

The present disclosure relates to a three-phase current detection device employed in a range of electronic apparatuses.

### BACKGROUND ART

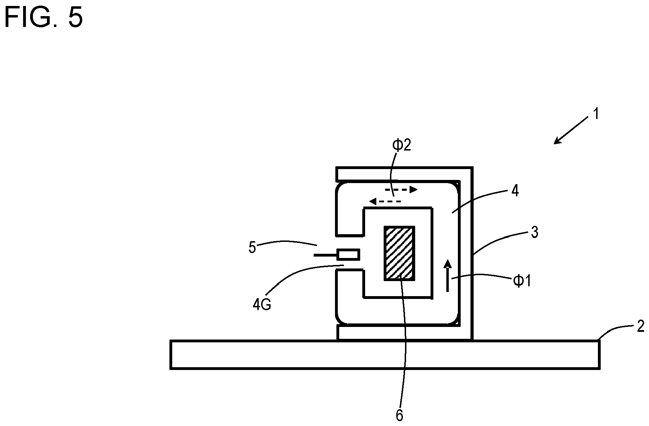

FIG. 5 is an appearance view of conventional current detection device 1. Current detection device 1 is disposed on substrate 2, and includes housing 3, magnetic core 4, and magnetoelectric conversion element 5. Magnetoelectric conversion element 5 is disposed in magnetic gap 4G provided in magnetic core 4. In current detection device 1, to obtain a value of current to be detected flowing in conductor 6, magnetoelectric conversion element 5 detects magnetic flux φ1 generated by current to be detected flowing in conductor 6 that passes through magnetic core 4.

For example, PTL1 discloses a conventional current detection device similar to current detection device 1.

### CITATION LIST

### PATENT LITERATURE

PTL1: Japanese Patent Laid-open Publication No. 2018-17651

### SUMMARY

A three-phase current detection device is configured to be used with first to third conductors allowing respective three-phase currents to flow therethrough in a flow direction, and is configured to detect the three-phase currents. The three-phase current detection device includes a substrate, a grounding wiring provided on the substrate, first to third loop magnetic cores, first to third magnetoelectric conversion elements, and first to third grounding electrodes. The first to third loop magnetic cores are extended along first to third loop lines surrounding the first to third conductors, the first to third loop lines are on a plane perpendicular to the flow direction, the first to third loop magnetic cores have first to third magnetic gaps, respectively. The first to third magnetoelectric conversion elements are disposed in the first to third magnetic gaps, respectively. The first to third grounding electrodes are connected to the grounding wiring, contact the first to third loop magnetic cores, and press the first to third loop magnetic cores in first to third pressing directions perpendicular to the flow direction, respectively.

This current detection device detects currents accurately.

### BRIEF DESCRIPTION OF DRAWINGS

FIG. 1 is a schematic side view of a three-phase current detection device in accordance with an exemplary embodiment.
FIG. 2 is a schematic side sectional view of the three-phase current detection device along line II-II shown in FIG. 1.
FIG. 3 is an exploded perspective view of the three-phase current detection device in accordance with the embodiment.
FIG. 4 is a schematic side view of another three-phase current detection device in accordance with the embodiment.
FIG. 5 is an appearance view of a conventional current detection device.

### DETAIL DESCRIPTION OF PREFERRED EMBODIMENT

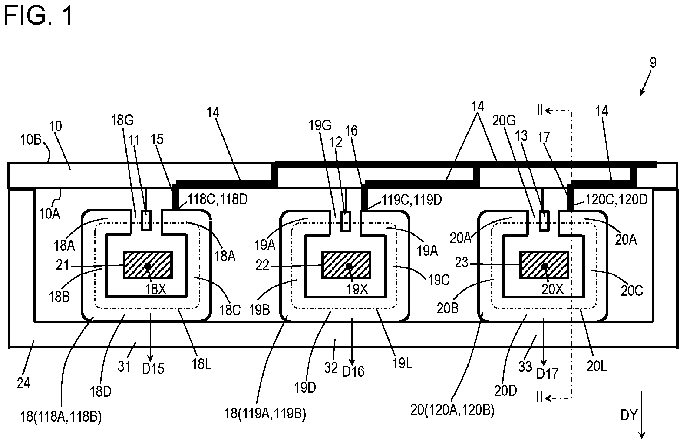

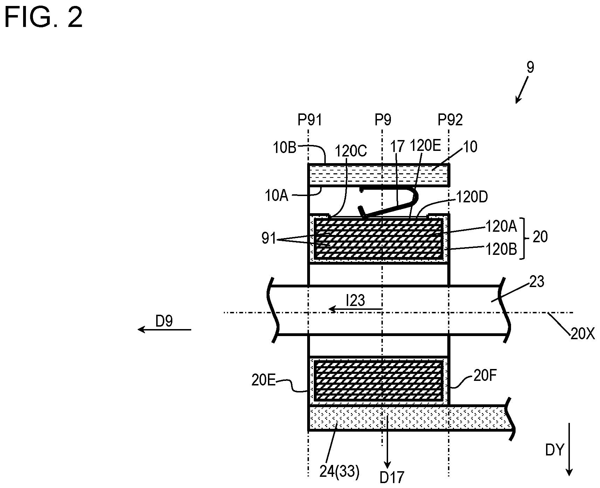

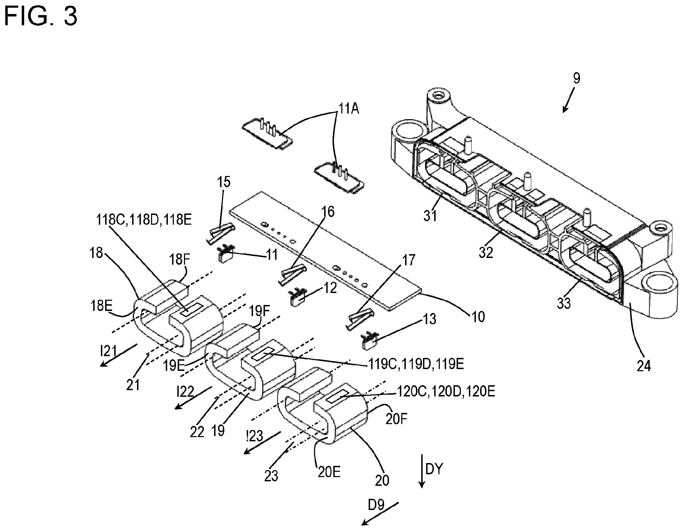

FIG. 1 is a schematic side view of three-phase current detection device 9 in accordance with an exemplary embodiment. FIG. 2 is a schematic side sectional view of three-phase current detection device 9 along line II-II shown in FIG.1. FIG. 3 is an exploded perspective view of three-phase current detection device 9.

Three-phase current detection device 9 is configured to be used with conductors 21, 22, and 23 extended in flow direction D9. Conductors 21, 22, and 23 are configured to allow currents 121, 122, and 123 to flow in flow direction D9. Three-phase current detection device 9 is configured to detect currents 121, 122, and 123.

Three-phase current detection device 9 includes substrate 10, magnetoelectric conversion elements 11, 12, and 13, grounding wiring 14, grounding electrodes 15, 16, and 17, and loop magnetic cores 18, 19, and 20. Loop magnetic cores 18, 19, and 20 are conductive, and made of iron in accordance with the embodiment.

Magnetoelectric conversion elements 11, 12, and 13 are disposed on substrate 10. Grounding wiring 14 is provided on substrate 10. Grounding electrodes 15, 16, and 17 are disposed on substrate 10, and connected to grounding wiring 14.

Magnetic gaps 18C, 19G, and 20G are provided in loop magnetic cores 18, 19, and 20, respectively. Magnetoelectric conversion element 11 is disposed in magnetic gap 18. Magnetoelectric conversion element 12 in magnetic gap 19G. Magnetoelectric conversion element 13 is disposed in magnetic gap 20G. Grounding electrodes 15, 16, and 17 press and contact loop magnetic cores 18, 19, and 20, respectively. In other words, grounding electrode 15 is sandwiched between substrate 10 and loop magnetic core 18 while being bent. Grounding electrode 16 is sandwiched between substrate 10 and loop magnetic core 19 while being bent. Grounding electrode 17 is sandwiched between substrate 10 and loop magnetic core 20 while being bent. Magnetoelectric conversion elements 11, 12, and 13 convert to electric signals, magnetic fields produced by currents 121, 122, and 123 to be measured that flow through conductors 21, 22, 23, respectively.

Conductors 21, 22, and 23 are extended along through-axes 18X, 19X, and 20X extended in flow direction D9.

Loop magnetic core 18 is extended along loop line 18L that surrounds conductor 21 (through-axis 18X). Loop line 18L is on plane P9 perpendicular to flow direction D9. Loop magnetic core 18 has magnetic gap 18G therein on loop line 18L. Loop magnetic core 19 is extended along loop line 19L that surrounds conductor 22 (through-axis 19X). Loop line 19L is on plane P9. Loop magnetic core 19 has magnetic gap 19G therein on loop line 19L. Loop magnetic core 20 is extended along loop line 20L that surrounds conductor 23 (through-axis 20X). Loop line 20L is on plane P9. Loop magnetic core 20 has magnetic gap 20G therein on loop line 20L.

Loop magnetic core 18 has end surface 18E located in flow direction D9, and end surface 18F opposite to end surface 18E. End surface 18F is located in a direction opposite to flow direction D9 from end surface 18E. Loop magnetic core 19 has end surface 19E located in in flow direction D9 and end surface 19F opposite to end surface 19E. End surface 19F is located in the direction opposite to flow direction D9 from end surface 19E. Loop magnetic core 20 has end surface 20E located in flow direction D9, and end surface 20F opposite to end surface 20E. End surface 20F is located in the direction opposite to flow direction D9 from end surface 20E. Respective one end surfaces 18E, 19E, and 20E of loop magnetic cores 18, 19, and 20 in flow direction D9 are flush with plane P91 parallel to plane P9. Respective other end surfaces 18F, 19F, and 20F of loop magnetic cores 18, 19, and 20 in flow direction D9 are flush with plane P92 parallel to plane P9.

In other words, respective loop surfaces (plane P9) of loop magnetic cores 18, 19, and 20 are flush with the same plane P9. Pressing direction D15 in which grounding electrode 15 applies a pressing force to loop magnetic core 18 is perpendicular to through-axis 18X of loop magnetic core 18. Similarly, pressing direction D16 in which grounding electrode 16 applies a pressing force to loop magnetic core 19 is perpendicular to through-axis 19X of loop magnetic core 19. Pressing direction D17 in which grounding electrode 17 applies a pressing force to loop magnetic core 20 is perpendicular to through-axis 20X of loop magnetic core 20. In accordance with the embodiment, pressing directions D15, D16, and D17 are identical to one another, and the same direction DY. However, at least two of pressing directions D15, D16, and D17 may be different from each other.

In the above configuration, loop magnetic core 18 is connected to grounding wiring 14 via grounding electrode 15. Therefore, generation of current in loop magnetic core 18, which is a conductor, can be suppressed. This configuration suppresses conversion of magnetic flux produced by current generated in loop magnetic core 18 into an electric signal as noise in magnetoelectric conversion element 11. This effect is exhibited in loop magnetic core 19 and loop magnetic core 20. As a result, three-phase current detection device 9 accurately detects currents I121, 122, and 123 to be measured that flow in respective phases.

In conventional current detection device 1 shown in FIG. 5, in the case that magnetic core 4 is made of conductive material, secondary magnetic flux φ2 is generated in magnetic core 4 due to eddy current produced inside magnetic core 4 by magnetic flux φ1. Magnetoelectric conversion element 5 also performs magnetoelectric conversion on magnetic flux φ2. As a result, magnetoelectric conversion element 5 outputs an electric signal corresponding to undesired magnetic flux φ2, in addition to the electric signal corresponding to magnetic flux φ1 that is to be originally detected. This may hinder accurate detection of the current.

As described above, three-phase current detection device 9 in accordance with the embodiment accurately detects currents 121, 122, and 123 to be measured.

Furthermore, respective loop surfaces of loop magnetic core 18, loop magnetic core 19, and loop magnetic core 20 are located substantially on the same plane P9. In addition, pressing direction D15 in which grounding electrode 15 applies the pressing force to loop magnetic core 18 is perpendicular to through-axis 18X of loop magnetic core 18. This configuration provides a positional relationship preventing magnetic fluxes which are emitted from conductors 21, 22, and 23 due to currents 121, 122, and 123 and which pass through loop magnetic cores 18, 19, and 20 from easily interlink with grounding electrodes 15, 16, and 17. Therefore, generation of current in grounding electrodes 15, 16, and 17 by magnetic flux produced by currents 121, 122, and 123 is suppressed to reduce power losses in currents 121, 122, and 123 accordingly. In particular, in a three-phase power circuit in which plural adjacent currents are detected, interference of one phase with another can be suppressed. Accordingly, three-phase current detection device 9 accurately detects currents 121, 122, and 123 flowing in respective phases.

Three-phase current detection device 9 will be detailed below. Three-phase current detection device 9 further includes housing 24 having a position relative to housing 24 is fixed. Housing 24 may be coupled to substrate 10, or housing 24 may cover substrate 10 and magnetic cores 18, 19, and 20. In other words, housing 24 secures relative positions of the substrate, loop magnetic cores 18, 19, and 20, and a device provided on substrate 10.

Magnetoelectric conversion elements 11, 12, and 13 are mounted and disposed on surface 10A of substrate 10. Grounding wiring 14 connected to the ground is disposed at substrate 10. Grounding wiring 14 may be disposed on the surface of substrate 10, or embedded in substrate 10. Alternatively, grounding wiring 14 may be wired on surface 10B opposite to surface 10A of substrate 10. Grounding wiring 14 is connected to grounding electrodes 15, 16, and 17 regardless of its position. In the embodiment, a hall element or hall IC is used as each of magnetoelectric conversion elements 11, 12, and 13, but other magnetoelectric conversion devices, such as a magnetoresistive element, may be used.

Magnetoelectric conversion elements 11, 12, and 13 are connected to control circuit 11A. Electric signals generated from magnetoelectric conversion elements 11, 12, and 13 may be converted to control signals for controlling a device, such as a power supply device, to be controlled by control circuit 11A. Control circuit 11A may be provided in three-phase current detection device 9 or outside three-phase current detection device 9.

Grounding electrodes 15, 16, and 17 are made of metals with a function of elastic spring. Grounding electrode 15 is conductive with grounding wiring 14, and also conductive with loop magnetic core 19 while contacting loop magnetic core 19.

The metal with a function of elastic spring allows grounding electrode 15 to reliably contact loop magnetic core 18 to secure high reliability of a conductive state. Grounding electrode 15 has elasticity in pressing direction D15, i.e., direction DY.

Loop magnetic core 18 is held by housing 24 coupled to substrate 10. Accordingly, the rough relative positional relationship among loop magnetic core 18, substrate 10, and housing 24 are predetermined by their dimensions. However, since loop magnetic core 18 is made of material with larger elastic modulus than substrate 10 and housing 24, dimensional deviation or positional deviation of loop magnetic core 18 are absorbed by deformation or bending of substrate 10, housing 24, and grounding electrode 15. Since deformation of substrate 10 and housing 24 involves deformation as three-phase current detection device 9, aforementioned deformation and bending are preferably absorbed by grounding electrode 15.

Therefore, an elastic modulus of grounding electrode 15 in pressing direction D15 (direction DY) is preferably smaller than an elastic modulus of loop magnetic core 18 in pressing direction D15 (direction DY), and also smaller than an elastic modulus of substrate 10 related to bending and deformation. Similarly, the elastic modulus of grounding electrode 15 in pressing direction D15 (direction DY) is preferably smaller than the elastic modulus of loop magnetic core 18 in pressing direction D15, and also smaller than an elastic modulus of housing 24 related to bending and deformation.

This configuration allows grounding electrode 15 to securely contact loop magnetic core 18 to ensure high reliability of the conductive state. As a result, currents 121, 122, and 123 that flow in respective phases of three-phase detection device 9 can be detected accurately.

The relation between grounding electrode 15 and loop magnetic core 18 in pressing direction D15 (direction DY) is described above. This relation is identical to the relation between grounding electrode 16 and loop magnetic core 19 in pressing direction D16 (direction DY) and the relation between grounding electrode 17 and loop magnetic core 20 in pressing direction D17 (direction DY).

As shown in FIG. 2, loop magnetic core 20 includes loop magnetic conductive part 120A made of conductive magnetic material, such as iron, and coating layer 120B covering loop magnetic conductive part 120A. Similarly, loop magnetic cores 18 and 19 include loop magnetic conductive parts 118A and 119A made of conductive magnetic material, such as iron, and coating layers 118B and 119B covering loop magnetic conductive parts 118A and 119A, respectively. Coating layers 118B, 119B, and 120B are made of coating material, such as resin material. In accordance with the embodiment, coating layers 118B, 119B, and 120B are insulative. This configuration suppresses a progress of corrosion, such as by rusting, of loop magnetic cores 18, 19, and 20 mainly made of iron in accordance with the embodiment. Loop magnetic cores 18, 19, and 20 is conductive with grounding electrodes 15, 16, and 17, respectively, and thus openings 118C, 119D, and 120C are provided in coating layers 118B, 119B, and 120B, respectively. Openings 118C, 119D, and 120C allow exposed parts 118D, 119D, and 120D of loop magnetic conductive parts 118A, 119A, and 120A to be exposed therethorugh, respectively. Grounding electrodes 15, 16, and 17 press loop magnetic cores 18, 19, and 20 by contacting exposed parts 118D, 119D, and 120D of loop magnetic conductive parts 118A 119A, and 120A of loop magnetic cores 18, 19, and 20 to press loop magnetic conductive parts 118A, 119A and 120A in pressing directions D15, D16, and D17, respectively. Loop magnetic cores 18, 19, and 20 may not necessarily include coating layers 118B, 119B, and 120B.

As described above, the material of loop magnetic cores 18, 19, and 20 (loop magnetic conductive parts 118A, 119A, and 120A) is not limited to pure iron. For example, the material may be silicon steal or nickel-iron alloy. Iron material is mainly used for the loop magnetic core in accordance with the embodiment. Magnetic material, such as permalloy, ferrite, or amorphous may be used for the loop magnetic core as required.

As described above, iron material is used for loop magnetic cores 18, 19, and 20 (loop magnetic conductive parts 118A, 119A, and 120A). However, the material is not necessarily pure iron, and may be iron compounds.

Coating layers 118B, 119B, and 120B may not necessarily have high insulation property. In three-phase current detection device 9, all of grounding electrodes 15, 16, and 17 are grounded and have the same potential. Therefore, an extremely large potential difference is hardly produced between each of loop magnetic cores 18, 19, 20 (loop magnetic conductive parts 118A, 119A, and 120A) and respective one of conductors 21, 22, and 23 in respective phase. Accordingly, the insulation property required for loop magnetic cores 18, 19, and 20 can be suppressed to a low value.

Openings 118C, 119C, and 120C and exposed parts 118D, 119D, and 120D may not necessarily have closed shapes, and may have slit shapes. This configuration increases contact areas of loop magnetic cores 18, 19, and 20 (loop magnetic conductive parts 118A, 119A, and 120A) contacting grounding electrodes 15, 16, and 17, respectively, providing high reliability of conductive state accordingly.

Coating agents 118E, 119E, and 120E, such as lubricating oil or gel resin, may be applied in openings 118C, 119C, and 120C to cover exposed parts 118D, 119D, and 120D, respectively. This configuration suppresses rusting or progress of corrosion on exposed parts 118D, 119D, and 120D of loop magnetic cores 18, 19, and 20 while maintaining an electrical conductive state between grounding electrode 15 and loop magnetic core 18 (loop magnetic conductive part 118A), an electrical conductive state between grounding electrode 16 and loop magnetic core 19 (loop magnetic conductive part 119A and an electrical conductive state between grounding electrode 17 and loop magnetic core 20 (loop magnetic conductive part 120A).

Coating agents 118E 119E and 120E suppresses wear of grounding electrodes 15, 16, and 17 caused by friction between each of grounding electrodes 15, 16, and 17 and respective one of exposed parts 118D, 119D and 120D of loop magnetic cores 18, 19, and 20. The agents suppress scattering of residue generated by friction between grounding electrodes 15, 16, and 17 and exposed parts 118D 119D, and 120D of loop magnetic cores 18, 19, and 20.

Openings 118C, 119C, and 120C and exposed parts 118D, 119D, and 120D constitute recesses provided in outer circumferential surfaces of loop magnetic cores 18, 19, and 20. This configuration increases the surface areas of coating agents 118E, 119E, and 120E provided as described above and contacting loop magnetic cores 18, 19, and 20, and suppresses outflow of coating agents 118E, 19E, and 120E from exposed parts 118D, 119D, and 120D. As a result, coating agents 118E, 119E, and 120E are typically retained. The recesses constituted by openings 118C, 119E, and 120E and exposed parts 118D, 119D, and 120D easily restrict positions on grounding electrodes 15, 16, and 17 pressing loop magnetic cores 18, 19, and 20. This configuration enhances reliability of electric conductive state between grounding electrodes 15, 16, and 17 and loop magnetic cores 18, 19, and 20 (loop magnetic conductive parts 118A, 119A and 120).

Coating agents 118E, 119E and 120E may be made of welding material, such as solder. Alternatively, coating agents 118E, 119E, and 120E may be formed by plating conductive metal.

As shown in FIG. 2, loop magnetic conductive part 120A (118A, 119A) of loop magnetic core 20 (18, 19) is preferably made of plural magnetic conductor strip 91 placed on one another. The magnetic conductor strips are stacked in a direction perpendicular to flow direction D9. Magnetic conductor strip 91 is made of magnetic conductive material, such as iron. This configuration suppresses eddy currents generated inside loop magnetic conductive parts 118A, 119A, and 120A of loop magnetic cores 18, 19, and 20. In this case, each magnetic conductor strip may be covered with a layer made of the same material as coating layer 118B (119B and 120B), and magnetic conductor strips 91 are placed on one another to constitute each of loop magnetic conductive parts 118A, 119A, and 120A of loop magnetic cores 18, 19, and 20. Alternatively, each of loop magnetic conductive materials of loop magnetic cores 18, 19, and 20 may be formed by forming coated layers 118B, 119B, and 120B after stacking magnetic conductor strips 91.

A method of manufacturing magnetic cores 18, 19, and 20 each made of magnetic conductor strips 91 will be described below. A magnetic conductive plate, such as a single long and thin steel plate, is spirally wound, and then, its end surfaces are flattened. Magnetic conductor strips 91 as a cut core formed by cutting magnetic gap 18G, 19G, and 20G may be stacked on one another. This configuration suppresses an internal stress to a low value while magnetic conductor strips 91 are stacked.

Loop magnetic cores 18, 19, and 20 each made of magnetic conductor strips 91 placed on one another substantially have rectangular shapes with four sides, viewed in flow direction D9: sides 18A, 19A, and 20A; sides 18B, 19B, and 20B; sides 18C, 19C, and 20C; and sides 18D, 19D, and 20D, respectively. Loop magnetic core 18 substantially has a rectangular shape with side 18A extended along loop line 18L and facing surface 10A of substrate 10, sides 18B and 18C extended along loop line 18L and each connected to respective one of both ends of side 18A, and side 18D extended along loop line 18L and connected to sides 18B and 18C at positions opposite to side 18A. Loop magnetic core 19 substantially has a rectangular shape with side 19A extended along loop line 19L and facing surface 10A of substrate 10, sides 19B and 19C extended along loop line 19L and each connected to respective one of both ends of side 19A, and side 19D extended along loop line 19L and connected to sides 19B and 18C at positions opposite to side 19A. Loop magnetic core 20 substantially has a rectangular shape with side 20A extended along loop line 20L and facing surface 10A of substrate 10, sides 20B and 20C extended along loop line 20L and each connected to respective one of both ends of side 20A, and side 20D extended along loop line 20L and connected to sides 20B and 20C at positions opposite to side 20A. Magnetic gaps 18G, 19G, and 20G are provided in sides 18A, 19A, and 20A, respectively. Magnetoelectric conversion elements 11, 12, and 13 mounted on substrate 10 are disposed in magnetic gaps 18G, 19G, and 20G, respectively. Outer circumferential surfaces of sides 18A, 19A and 20A face substrate 10. Exposed parts 118D, 119D, and 119D are provided on the outer circumferential surfaces of sides 18A, 19A, and 20A, respectively. Sides 18B and 18C are disposed on both sides of side 18A. Sides 19B and 19C are disposed on both sides of side 19A. Each of sides 20B and 20 is disposed on respective one of both ends of side 20A. Side 18D is disposed opposite to side 18A such that each of sides 18B and 18C is disposed on respective one of both ends of side 18D. Side 19D is disposed opposite to side 19A such that each of sides 19B and 19C is disposed on respective one of both ends of side 19D. Side 20D is disposed opposite to side 20A such that each of sides 20B and 20C is disposed on respective one of both sides of side 20D. In other words, sides 18D, 19D, and 20D face parts 31 32, and 33 of housing 24, respectively. Alternatively, sides 18D, 19D, and 20D may be supported by parts 31, 32, and 33 of housing 24 by contacting parts 31, 32, and 33 of housing 24, respectively.

As described above, each of loop magnetic cores 18, 19, and 20 is made of, e.g. a single long and thin magnetic conductor plate wound spirally and has a flat end surface. Magnetic gaps 18G, 19G, and 20G are formed typically by cutting the wound magnetic conductor plate to form cut cores that are used as loop magnetic cores 18, 19, and 20. Therefore, loop magnetic cores 18, 19, and 20 have internal stress due to being, although a little, bent or wound. Magnetic gaps 18G, 19G, and 20G may cause sides 18A, 19A, and 20A to tend to change their positions most in all sides of loop magnetic cores 18, 19, and 20 when the above-described stress is released. Therefore, grounding electrodes 15, 16, and 17 preferably contact sides 18A, 19A, and 20A of loop magnetic cores 18, 19, and 20, respectively.

The stress of loop magnetic core 18 tends to be released in a direction perpendicular to through-axis 18X of loop magnetic core 18. In this direction, grounding electrode 15 is disposed at a position where the stress is most likely released. Grounding electrode 15 has an elastic modulus smaller than loop magnetic core 18 and is capable of absorbing the stress. Therefore, loop magnetic core 18 and grounding electrode 15 can retain a stable contact state. Grounding electrode 15 absorbs an amount of deformation of loop magnetic core 18 to retain the stable contact state. This is identical for grounding electrode 16 and loop magnetic core 19, and same for grounding electrode 17 and loop magnetic core 20. Directions of through-axes 18X, 19X, and 20X of loop magnetic cores 18, 19, and 20 are identical to directions in which conductors 21, 22, and 23 pass through the loop surfaces (plane P9) of loop magnetic cores 18, 19, and 20.

Exposed part 118D is provided at a position on side 18A toward side 18C with respect to magnetic gap 18G. Exposed part 119D is provided at a position on side 19A toward side 19C with respect to magnetic gap 19G. Exposed part 120D is provided at a position on side 20A toward side 20C with respect to magnetic gap 20G. In other words, exposed part 118D is provided between side 18C and magnetic gap 18G in side 18A. Exposed part 119D is provided between side 19C and magnetic gap 19G in side 19A. Exposed part 120D is provided between side 20C and magnetic gap 20G in side 20A. Exposed part 118D may be provided at a position on side 18A toward either of side 18B or 18C with respect to magnetic gap 18G. Exposed part 119D may be provided at a position on side 19A toward either one of side 19B or 19C with respect to magnetic gap 19G. Exposed part 120D may be provided at a position on side 20A toward either of side 20B or 20C with respect to magnetic gap 20G.

As described above, three-phase current detection device 9 ensures the contact state of grounding electrodes 15, 16, and 17 and loop magnetic cores 18, 19, and 20 to secure a highly-reliable conductive state. As a result, three-phase current detection device 9 accurately detect currents 121, 122, and 123 flowing in respective phases.

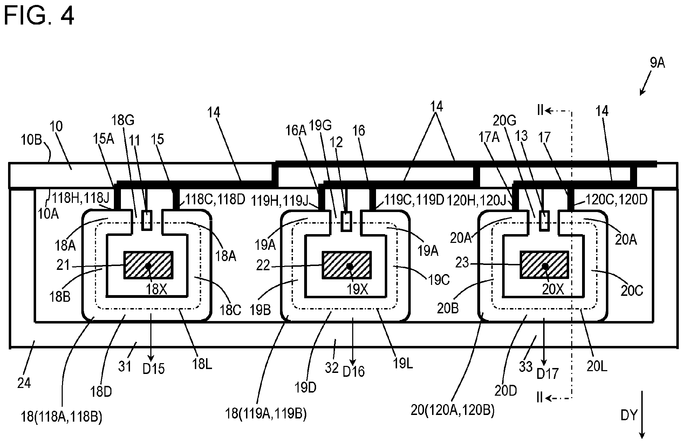

FIG. 4 is a schematic side view of another three-phase current detection device 9A in accordance with the embodiment. In FIG. 4, components identical to those of three-phase current detection device 9 shown in FIGs. 1 to 3 are denoted by the same reference numerals. Three-phase current detection device 9A further includes grounding electrodes 15A, 16A, and 17A made of the same material and have the same shapes as grounding electrodes 15, 16, and 17 of three-phase current detection device 9. In three-phase current detection device 9A, loop magnetic cores 18, 19, and 20 further have openings 118H, 119H, and 120H and exposed parts 118J, 119J, and 120J identical to openings 118C, 119C, and 120C and exposed parts 118D, 119D, and 120D, respectively.

Exposed part 118J is provided at a position on side 18A toward side 18B with respect to magnetic gap 18G. Exposed part 119J is provided at a position on side 19A toward side 19B with respect to magnetic gap 19G. Exposed part 120J is provided at a position on side 20A toward side 20B with respect to magnetic gap 20G. In other words, exposed part 118J is provided between side B and magnetic gap 18G in side 18A. Exposed part 119J is provided between side 19B and magnetic gap 19G in side 19A. Exposed part 120J is provided between side 20B and magnetic gap 20G in side 20A.

Similarly to grounding electrodes 15, 16, and 17, grounding electrodes 15A, 16A, and 17A are disposed on surface 10A of substrate 10 and connected to grounding wiring 14. Coating layer 118B of loop magnetic core 18 has opening 118H to expose exposed part 118J of loop magnetic conductor 118A therethrough, similarly to opening 118C. Grounding electrode 15A contacts exposed part 118J of loop magnetic conductive part 118A to press loop magnetic core 18 in pressing direction D15. Coating layer 119B of loop magnetic core 19 has opening 119H to expose exposed part 119J of loop magnetic conductive part 119A therethrough, similarly to opening 119C. Grounding electrode 16A contacts exposed part 119J of loop magnetic conductive part 119A to press loop magnetic core 19 in pressing direction D16. Coating layer 120B of loop magnetic core 20 has opening 120H to expose exposed part 120J of loop magnetic conductive part 120A therethrough, similarly to opening 120C. Grounding electrode 17A contacts exposed part 120J of loop magnetic conductive part 129A to press loop magnetic core 20 in pressing direction D17.

Three-phase current detection device 9A ensures contact between grounding electrodes 15 and 15A and loop magnetic core18, contact between grounding electrodes 16 and 16A and loop magnetic core 19, and contact between grounding electrodes 17 and 17A and loop magnetic core 20, so as to secure highly-reliable conductive state. As a result, three-phase current detection device 9A accurately detect currents 121, 122, and 123 that flow in respective phases.

### REFERENCE MARKS IN THE DRAWINGS

9 three-phase current detection device
10 substrate
11 magnetoelectric conversion element (first magnetoelectric conversion element)
   11A control circuit
12 magnetoelectric conversion element (second magnetoelectric conversion element)
13 magnetoelectric conversion element (third magnetoelectric conversion element)
14 grounding wiring
15 grounding electrode (first grounding electrode)
16 grounding electrode (second grounding electrode)
17 grounding electrode (third grounding electrode)
18 loop magnetic core (first loop magnetic core)
18A, 19A, 20A side (first side)
18B, 19B, 20B side (second side)
18C, 19C, 20C side (third side)
18D, 19D, 20D side (fourth side)
18G magnetic gap (first magnetic gap)
19 loop magnetic core (second magnetic core)
19G magnetic gap (second magnetic gap)
20 loop magnetic core (third loop magnetic core)
20G magnetic gap (third magnetic gap)
21 conductor (first conductor)
22 conductor (second conductor)
23 conductor (third conductor)
24 housing
25A exposure opening (first opening)
25B exposure opening (second opening)
25C exposure opening (third opening)
26A exposed part (first exposed part)
26B exposed part (second exposed part)
26C exposed part (third exposed part)

## Claims

1. A three-phase current detection device configured to be used with a first conductor, a second conductor, and a third conductor which are extended in a flow direction and allow respective three-phase currents to flow therethrough in the flow direction, the three-phase current detection device being configured to detect the three-phase currents, the three-phase current detection device comprising:
a substrate;
a grounding wiring provided on the substrate;
a first loop magnetic core extended along a first loop line surrounding the first conductor, the first loop line being on a plane perpendicular to the flow direction, the first loop magnetic core having conductivity, the first loop magnetic core having a first magnetic gap therein located on the first loop line;
a second loop magnetic core extended along a second loop line surrounding the second conductor, the second loop line being on the plane, the second loop magnetic core having conductivity, the second loop magnetic core having a second magnetic gap therein located on the second loop line;
a third loop magnetic core extended along a third loop line surrounding the third conductor, the third loop line being on the plane, the third loop magnetic core having conductivity, the third loop magnetic core having a third magnetic gap therein located on the third loop line;
a first magnetoelectric conversion element disposed in the first magnetic gap, the first magnetoelectric conversion element being configured to convert, to an electric signal, a magnetic field generated by a current flowing in the first conductor;
a second magnetoelectric conversion element disposed in the second magnetic gap, the second magnetoelectric conversion element being configured to convert, to an electric signal, a magnetic field generated by a current flowing in the second conductor;
a third magnetoelectric conversion element disposed in the third magnetic gap, the third magnetoelectric conversion element being configured to convert, to an electric signal, a magnetic field generated by a current flowing in the third conductor;
a first grounding electrode disposed on the substrate and connected to the grounding wiring, the first grounding electrode contacting the first loop magnetic core and pressing the first loop magnetic core in a first pressing direction perpendicular to the flow direction;
a second grounding electrode disposed on the substrate and connected to the grounding wiring, the second grounding electrode contacting the second loop magnetic core and pressing the second loop magnetic core in a second pressing direction perpendicular to the flow direction; and
a third grounding electrode disposed on the substrate and connected to the grounding wiring, the third grounding electrode contacting the third loop magnetic core and pressing the third loop magnetic core in a third pressing direction perpendicular to the flow direction.

2. The three-phase current detection device according to claim 1, wherein
the first loop magnetic core includes a first loop magnetic conductive part and a first coating layer covering the first loop magnetic conductive part, the first coating layer having an opening to expose a first exposed part of the first loop magnetic conductive part therethrough,
the second loop magnetic core includes a second loop magnetic conductive part and a second coating layer covering the second loop magnetic conductive part, the second coating layer having an opening to expose a second exposed part of the second loop magnetic conductive part therethrough,
a third loop magnetic core includes a third loop magnetic conductive part and a third coating layer covering the third loop magnetic conductive part, the third coating layer having an opening to expose a third exposed part of the third loop magnetic conductive part therethrough,
the first grounding electrode contacts the first exposed part of the first loop magnetic core,
the second grounding electrode contacts the first exposed part of the second loop magnetic core, and
the third grounding electrode contacts the third exposed part of the third loop magnetic core.

3. The three-phase current detection device according to claim 2, wherein each of the first loop magnetic conductive part of the first loop magnetic core, the second loop magnetic conductive part of the second loop magnetic core, and the third loop magnetic conductive part of the third loop magnetic core is made of a plurality of strip magnetic conductors placed on one another.

4. The three-phase current detection device according to claim 3, wherein the plurality of magnetic conductor strips are overlapped in a direction perpendicular to the flow direction.

5. The three-phase current detection device according to any one of claims 2 to 4, wherein
the first loop magnetic core substantially has a rectangular shape with a first side extended along the first loop line and facing the substrate, a second side and a third side extended along the first loop line and connected to both ends of the first side, respectively, and a fourth side extended along the first loop line and connected to the second side of the first loop magnetic core and the third side of the first loop magnetic core at positions opposite to the first side of the first loop magnetic core,
the second loop magnetic core substantially has a rectangular shape with a first side extended along the second loop line and facing the substrate, a second side and a third side extended along the second loop line and connected to both ends of the first side of the second loop magnetic core, respectively, and a fourth side extended along the second loop line and connected to the second side of the second loop magnetic core and the third side of the second loop magnetic core at positions opposite to the first side of the second loop magnetic core,
the third loop magnetic core substantially has a rectangular shape with a first side extended along the third loop line and facing the substrate, a second side and a third side extended along the third loop line and connected to both ends of the first side of the third loop magnetic core, respectively, and a fourth side extended along the third loop line of the third loop magnetic core and connected to the second side of the third loop magnetic core and the third side of the third loop magnetic core on a side opposite to the first side of the third loop magnetic core,
the first exposed part is provided on the first side of the first loop magnetic core,
the second exposed part is provided on the first side of the second loop magnetic core, and
the third exposed part is provided on the first side of the third loop magnetic core.

6. The three-phase current detection device according to claim 5, wherein
the first magnetic gap is provided in the first side of the first loop magnetic core,
the second magnetic gap is provided in the first side of the second loop magnetic core, and
the third magnetic gap is provided in the first side of the third loop magnetic core.

7. The three-phase current detection device according to claim 1, wherein each of the first loop magnetic core, the second loop magnetic core, and third loop magnetic core includes a plurality of magnetic conductor strips placed on one another.

8. The three-phase current detection device according to claim 7, wherein the plurality of magnetic conductor strips are stacked in a direction perpendicular to the flow direction.

9. The three-phase current detection device according to any one of claims 1 to 8, wherein
respective one end surfaces of the first loop magnetic core, the second loop magnetic core, and the third loop magnetic core in the flow direction is flush with a plane parallel to the plane, and
respective other end surfaces of the first loop magnetic core, the second loop magnetic core, and the third loop magnetic core in the flow direction is flush with a plane parallel to the plane.

10. The three-phase current detection device according to any one of claims 1 to 9, further comprising:
a housing including a first part located in the first pressing direction from the first loop magnetic core, a second part located in the second pressing direction from the second loop magnetic core, and a third part located in the third pressing direction from the third loop magnetic core, the first part of the housing contacting the first loop magnetic core, the second part of the housing contacting the second loop magnetic core, the third part of the housing contacting the third loop magnetic core, wherein
the first grounding electrode presses the first loop magnetic core in the first pressing direction such that the first loop magnetic core is pressed toward the first part of the housing,
the second grounding electrode presses the second loop magnetic core in the second pressing direction such that the second loop magnetic core is pressed toward the second part of the housing, and
the third grounding electrode presses the third loop magnetic core in the third pressing direction such that the third loop magnetic core is pressed toward the third part of the housing.

11. The three-phase current detection device according to any one of claims 1 to 10, wherein the first pressing direction, the second pressing direction, and the third pressing direction are identical to one another.

12. The three-phase current detection device according to any one of claims 1 to 11, wherein the first loop magnetic core, the second loop magnetic core, and the third loop magnetic core are made of iron.
